Europäisches Patentamt

European Patent Office

Office européen des brevets

(19)

(11) Numéro de publication: **0 301 963**
**A2**

## (12) DEMANDE DE BREVET EUROPEEN

(21) Numéro de dépôt: 88401952.2

(22) Date de dépôt: 27.07.88

(51) Int. Cl.⁴: **H 04 B 9/00**
**H 03 F 3/08**

(30) Priorité: 30.07.87 FR 8710831

(43) Date de publication de la demande:
**01.02.89 Bulletin 89/05**

(84) Etats contractants désignés:
**BE CH DE ES FR GB GR IT LI LU NL SE**

(71) Demandeur: **SOCIETE MODERNE D'ELECTRONIQUE**
**Villa Mallebay 88 rue Didot**
**F-75014 Paris (FR)**

(72) Inventeur: **Terol, Jacques Marcel**
**14, rue Frédérick Lemaitre**
**F-75020 Paris (FR)**

(74) Mandataire: **Plaçais, Jean-Yves et.al**
**Cabinet Netter 40, rue Vignon**
**F-75009 Paris (FR)**

(54) **Dispositif amplificateur de signaux de faible puissance, notamment issus d'une fibre optique plastique.**

(57) La présente invention concerne un dispositif amplificateur à entrée analogique de faible puissance et à sortie logique, comprenant un étage d'entrée (1) formant préamplificateur à bas niveau et haute impédance, des moyens amplificateurs intermédiaires (2) et un étage de sortie (3) propre à transformer la sortie de ces moyens amplificateurs intermédiaires (2) en signal logique. Des moyens amplificateurs intermédiaires (2) comprennent un premier étage (5) dont le point de fonctionnement est réglé entre un état de blocage correspondant à la délivrance par l'étage de sortie (3) d'un signal logique à l'état bas et un état de début de conduction correspondant à la délivrance par l'étage de sortie d'un signal logique à l'état haut. Les moyens amplificateurs intermédiaires comprennent en outre une boucle d'asservissement du point de fonctionnement dudit premier étage (5).

Utilisation, notamment, pour détecter à distance le déplacement relatif de deux éléments, en particulier pour un équipement de protection de porte ou de fenêtre.

FIG. 1

# Description

## Dispositif amplificateur de signaux de faible puissance, notamment issus d'une fibre optique plastique.

La présente invention concerne un dispositif amplificateur de signaux de faible puissance, notamment issus d'une fibre optique plastique.

La transmission d'informations numériques entre appareils devient de plus en plus essentielle dans les processus. Elle doit être fiable, non parasitable, difficilement sabotable ou piratable. Parmi les liaisons classiques de transmission d'informations, les fibres optiques ont été choisies pour répondre à ces critères.

Deux types de fibres existent actuellement : les fibres en verre, et les fibres plastiques. Les fibres en verre sont fragiles, coûteuses à mettre en oeuvre, mais ont une très faible atténuation linéique; par contre, les fibres plastiques sont robustes, d'utilisation facile mais atténuent énormément la lumière. Pour des applications dans les domaines industriels et grand public, les fibres optiques plastiques conviennent parfaitement comme support de transmission.

La réception d'informations transmises par fibres optiques plastiques nécessite l'utilisation de dispositifs amplificateurs à très grand gain et à vitesse élevée, car, outre l'atténuation de la lumière transmise, le débit d'informa tions souhaité est en général élevé. De plus, dans le cas où l'arrivée d'informations ne peut être prévue, le récepteur doit être alimenté en permanence et recevoir l'énergie nécessaire à l'amplification de la lumière.

Les dispositifs amplificateurs actuels autorisent des liaisons par fibres optiques plastiques sur une distance d'une centaine de mètres. De plus, leur consommation minimum au repos est de l'ordre d'une dizaine de milliampères. L'état de repos d'un dispositif amplificateur s'entend lorsque celui-ci ne reçoit pas de signal lumineux provenant de la fibre optique. Lorsqu'un signal lumineux est transmis, le dispositif amplificateur passe alors dans un état de travail.

La consommation minimum au repos des dispositifs amplificateurs actuels est prohibitive si ceux-ci sont couplés à des systèmes devant posséder une grande autonomie, par exemple un radar de surveillance alimenté par pile avec une autonomie de plusieurs années. Cette consommation est d'autant plus prohibitive si les dispositifs amplificateurs reliés à une fibre optique, notamment pour détecter une tentative d'effraction d'une porte, sont utilisés pour fonctionner en "logique négative", c'est-à-dire fonctionnant à l'état de travail, lorsqu'il n'y a pas de rupture de la fibre (tentative d'effraction) et fonctionnant à l'état de repos lorsqu'il y a tentative d'effraction (rupture de la fibre et interruption de la transmission lumineuse). Dans les cas d'utilisation en "logique négative", la longueur de la fibre optique plastique peut être importante, et par conséquent le gain du dispositif amplificateur doit être élevé, ce qui contribue à augmenter la consommation.

La présente invention remédie à ces inconvénients en proposant un dispositif amplificateur ayant une consommation extrêmement faible, notamment à l'état de repos. De plus, le dispositif amplificateur selon l'invention a un grand gain et une vitesse élevée.

La présente invention a donc pour objet un dispositif amplificateur à entrée analogique de faible puissance et à sortie logique, notamment adaptable sur un capteur, en particulier une photodiode, comprenant un étage d'entrée formant préamplificateur à bas niveau et haute impédance, des moyens amplificateurs intermédiaires et un étage de sortie propre à transformer la sortie de ces moyens amplificateurs intermédiaires en signal logique, caractérisé en ce que les moyens amplificateurs intermédiaires comprennent un premier étage dont le point de fonctionnement est réglé entre un état de blocage correspondant à la délivrance par l'étage de sortie d'un signal logique à l'état bas et un état de début de conduction correspondant à la délivrance par l'étage de sortie d'un signal logique à l'état haut.

Avantageusement l'étage d'entrée formant préamplificateur comprend un transistor bipolaire opérant à très faible courant de collecteur, ledit premier étage pouvant comprendre un transistor bipolaire de polarité opposée, dont le point de fonctionnement est réglé entre ledit état de blocage et ledit état de début de conduction, dont la maille base-émetteur comprend la résistance de collecteur du transistor de l'étage d'entrée, laquelle a une valeur faible par rapport à l'impédance équivalente base-émetteur dudit transistor bipolaire du premier étage lorsque ledit premier étage est à l'état de blocage, et ladite impédance équivalente a une valeur faible par rapport à ladite résistance de collecteur lorsque ledit premier étage est à l'état de début de conduction.

De préférence, la maille base-émetteur du transistor bipolaire dudit premier étage comprend en outre un étage anti-saturation constitué d'une résistance supplémentaire placée entre la base et l'émetteur du transistor bipolaire du premier étage et d'une résistance de liaison placée entre le collecteur du transistor bipolaire de l'étage d'entrée et la base du transistor bipolaire du premier étage.

Les moyens amplificateurs intermédiaires peuvent comprendre en outre une boucle d'asservissement du point de fonctionnement dudit premier étage. De préférence, la boucle d'asservissement est constituée, d'une part, d'un étage comparateur, comparant une information relative au point de fonctionnement dudit premier étage avec une information de référence, d'autre part un étage intégrateur pour régler ledit point de fonctionnement.

Les moyens amplificateurs intermédiaires comprennent avantageusement, en outre, un étage relais situé entre ledit premier étage et, d'une part, ledit étage de sortie et, d'autre part, ladite boucle d'asservissement.

L'étage relais est de préférence constitué d'un transistor bipolaire de polarité opposée à celle du transistor bipolaire du premier étage; la base du transistor bipolaire dudit étage relais est avantageusement reliée au collecteur du transistor bipolaire dudit premier étage, et le collecteur du transistor bipolaire dudit étage relais est de préférence relié à l'étage de sortie, l'émetteur du transistor bipolaire dudit étage relais étant relié à l'entrée de la boucle d'asservissement.

L'étage relais peut également assurer une fonction de miroir afin de renvoyer les signaux émis par ledit premier étage vers l'étage de sortie et la boucle d'asservissement.

L'étage comparateur de la boucle d'asservissement est avantageusement constitué d'un transistor bipolaire de polarité identique à celui dudit étage d'entrée dont la base est reliée à la sortie de l'étage relais et dont le collecteur est relié à l'entrée du circuit intégrateur, ladite information de référence étant définie par sa tension de seuil base-émetteur.

L'étage intégrateur comprend, de préférence, un transistor à effet de champ d'une polarité identique au transistor bipolaire du premier étage, dont la grille est reliée au collecteur du transistor bipolaire de l'étage comparateur.

Le dispositif amplificateur selon l'invention peut comprendre en outre une photodiode montée à l'entrée de l'étage d'entrée.

L'étage d'entrée, l'étage de sortie et les moyens intermédiaires sont avantageusement logés dans un support opaque comprenant un connecteur mâle muni de moyens d'attache et susceptible de recevoir un connecteur femelle d'une fibre optique, notamment plastique.

Afin de mieux faire comprendre l'objet de la présente invention, on va en décrire ci-après à titre purement illustratif et non limitatif, un mode de réalisation représenté sur les dessins ci-annexés.

Sur ces dessins :

- la figure 1 est un schéma de principe d'un dispositif amplificateur selon l'invention, et

- la figure 2 est une vue en perspective d'un support permettant de loger les différents constituants du dispositif amplificateur.

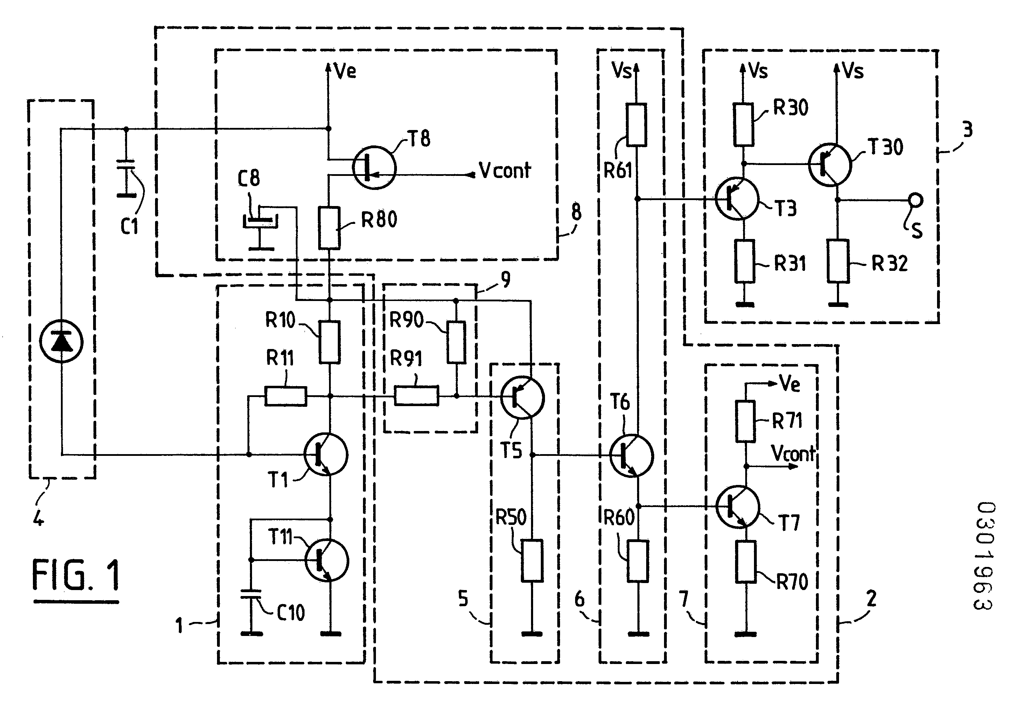

Si l'on se réfère à la figure 1, on voit que le dispositif amplificateur comprend un étage d'entrée 1 formant préamplificateur à bas niveau et haute impédance, des moyens amplificateurs intermédiaires 2 et un étage de sortie 3 propre à transformer la sortie de ces moyens amplificateurs intermédiaires 2 en signal logique. Le dispositif amplificateur comprend en outre une photodiode 4 montée à l'entrée de l'étage d'entrée 1. La cathode de la photodiode 4 est reliée à la tension d'alimentation Ve qui polarise cette dernière 4 .

L'étage d'entrée 1 est constitué d'un transistor NPN T1 dont la base est reliée à l'anode de la photodiode 4. Ce transistor T1 a une résistance de collecteur R10 et une résistance de contre-réaction R11 placée entre le collecteur et la base du transistor T1. Il fonctionne en régime linéaire mais est polarisé à courant collecteur très faible comme expliqué ci-après. L'étage d'entrée 1 comporte en outre un transistor NPN T11 dont la base et le collecteur sont reliés, et la jonction base-collecteur assimile donc le transistor T11 à une diode. Le collecteur du transistor T11 est, de plus, relié à l'émetteur du transistor T1 et l'émetteur du transistor T11 est relié à la masse. La base du transistor T11 est également reliée à la masse par l'intermédiaire d'un condensateur C10. L'ensemble condensateur C10 transistor T11 réalise une polarisation de l'émetteur du transistor T1 et la faible résistance dynamique du transistor T11, associée au condensateur C10 réalise un découplage du transistor T1.

Les moyens amplificateurs intermédiaires 2 comportent, en premier lieu, un premier étage 5, en deuxième lieu un étage relais 6, en troisième lieu un étage comparateur 7, en quatrième lieu un étage intégrateur 8 et en cinquième lieu un étage anti-saturation 9.

Le premier étage 5 est constitué d'un transistor PNP T5 dont le point de fonctionnement se situe à la limite du blocage et du début de la conduction. Son impédance d'entrée est très élevée, de l'ordre de plusieurs mégohms. Ce transistor T5 a une résistance de collecteur R50 et sa maille base-émetteur comporte la résistance de collecteur R10 du transistor T1 de l'étage d'entrée 1. La résistance R10 doit être faible par rapport à l'impédance équivalente base-émetteur H11 du transistor T5 dans l'état de blocage mais grande par rapport à H11 au seuil de début de conduction. La base du transistor T5 est reliée au collecteur du transistor T1 par l'intermédiaire d'une résistance de liaison R91 et une résistance supplémentaire R90 est placée entre la base du transistor T5 et son émetteur. Les deux résistances R91 et R90 constituent l'étage anti-saturation 9. Cet étage anti-saturation 9 n'est pas indispensable mais il est nécessaire dans certains cas d'utilisation évoqués ci-après. A cet effet, la valeur de la résistance R91 doit être choisie du même ordre de grandeur que l'impédance équivalente base-émetteur H11 du transistor T5 lors de l'amplification de forts signaux. De même, l'ensemble R90 en parallèle avec H11 doit être négligeable devant la résistance R10 en présence de faibles signaux.

L'étage relais 6 est constitué d'un transistor NPN T6 ayant une résistance d'émetteur R60 et une résistance de collecteur R61 reliée à la tension d'alimentation VS. Ce transistor T6 a également un point de fonctionnement se situant à la limite du blocage et du début de conduction. La résistance R60 réalise une contre-réaction d'émetteur afin d'augmenter la bande passante du transistor T6 mais fournit une mesure proportionnelle au courant de collecteur du transistor T5, donc une information relative à son point de fonctionnement. La base du transistor T6 est reliée au collecteur du transistor T5. Le collecteur du transistor T6 constitue une première borne de sortie de l'étage relais 6 vers l'étage de sortie 3 et l'émetteur du transistor T6 constitue une seconde borne de sortie vers l'étage comparateur 7.

L'étage de sortie 3 comprend un transistor PNP T3 ayant une résistance de collecteur R31 et une résistance d'émetteur R30. La base de ce transistor T3 est reliée à la première borne de sortie de l'étage relais 6, donc au collecteur du transistor T6. Ce transistor T3 a également un point de fonctionnement se situant à la limite du blocage de la conduction. Il fonctionne à faible courant d'émetteur. Sa polarisation est fixée par le courant dans la résistance R61. Ce transistor T3 réalise donc une adaptation d'impédance ainsi qu'une amplification en courant. L'étage de sortie 3 comprend en outre un transistor T30 dont la base est reliée à l'émetteur du transistor T3, dont l'émetteur est relié à la tension d'alimentation VS, et dont le collecteur est relié à la masse par l'intermédiaire d'une résistance de collecteur R32, le collecteur du transistor T30 constituant la borne de sortie S du dispositif amplificateur. Ce transistor T30 fonctionne en commutation, et fait apparaître, lorsqu'il est saturé, une tension sensiblement égale à VS, à la borne de sortie du dispositif amplificateur.

L'étage comparateur 7 est constitué d'un transistor NPN T7 dont l'émetteur est relié à la masse par une résistance d'émetteur R70 et dont la base est reliée à la seconde borne de sortie de l'étage relais, donc à l'émetteur du transistor T6. La tension de référence de ce comparateur est déterminée par le seuil base-émetteur du transistor T7. Une sortie du comparateur 7 est constituée par le collecteur du transistor T7 et délivre une tension Vcont. Le collecteur de ce transistor T7 est relié, par l'intermédiaire d'une résistance de collecteur R71, à la tension d'alimentation Ve.

L'étage intégrateur 8 comprend un transistor à effet de champ T8 du type FET canal N dont la grille est reliée au collecteur du transistor T7 de l'étage comparateur et dont le drain est relié à la tension d'alimentation Ve. L'utilisation d'un transistor à effet de champ permet, outre une impédance d'entrée élevée, une grande variation de la tension de commande Vcont de l'ordre de plusieurs volts. Une résistance de source R80 est placée entre la source du transistor à effet de champ T8 et la résistance de collecteur R10 du transistor T1. Le point de connexion entre la résistance R80 et la résistance R10 est relié à la borne d'un condensateur C8 dont l'autre borne est reliée à la masse. Le drain du transistor T8 est relié à la première borne d'un condensateur de découplage C1 dont l'autre borne est reliée à la masse, la première borne du condensateur C1 étant reliée à la cathode de la photodiode 4.

L'étage comparateur 7 et l'étage intégrateur 8 constituent une boucle d'asservissement du point de fonctionnement du transistor T5 du premier étage 5, la résistance de source R80 limitant le gain de cette boucle d'asservissement et le condensateur C2 réalisant l'intégration du courant délivré par le transistor à effet de champ T8.

Le fonctionnement de ce dispositif amplificateur va être décrit ci-après.

Lorsque la photodiode reçoit une émission lumineuse, elle délivre alors un courant qui est injecté dans la base du transistor T1. Si le signal reçu par la photodiode 4 est faible ou autrement dit si le courant de base injecté dans T1 est faible (ce qui correspond à un état de repos), on aura alors une faible variation du courant collecteur dans le transistor T1. Ceci ne modifiera donc pas le point de fonctionnement du transistor T5 et la valeur du courant de collecteur du transistor T1 est alors fournie par la résistance de collecteur R10. Dès que le courant injecté dans la base du transistor T1 est suffisant (c'est-à-dire en état de travail), il apparaît donc une variation significative du courant collecteur de ce transistor. Le point de fonctionnement du transistor T5 évolue donc. Le transistor T5 va passer d'un état de blocage à un état de début de conduction et son impédance d'entrée équivalente base-émetteur H11 diminue considérablement passant de quelques mégohms à quelques dizaines de kilo-ohms et donc la résistance de collecteur R10 du transistor T1 qui était de valeur élevée devient négligeable par rapport à cette impédance d'entrée du transistor T5. Tout le courant collecteur du transistor T1 est alors fourni par la base du transistor T5 et non par la résistance de collecteur R10. Le courant collecteur du transistor T5 augmente alors énormément.

Ce fonctionnement a été obtenu parce que, d'une part, au repos, R10 est faible par rapport à l'impédance d'entrée équivalente base-émetteur du transistor T5 et, d'autre part, parce que, au seuil du début de conduction, l'impédance équivalente base-émetteur du transistor T5 est faible par rapport à la résistance de collecteur R10 du transistor T1.

Le courant collecteur du transistor T5 est alors amplifié par le transistor T6 de l'étage relais polarisé comme le transistor T5 à la limite du blocage et du début de conduction. Son courant collecteur est donc minimum au repos et devient très grand dès que le transistor T5 se débloque. La résistance de collecteur R50 du transistor T5 impose un courant de collecteur du transistor T5 minimum afin de polariser correctement le transistor T6. La résistance R60, réalisant une contre-réaction d'émetteur du transistor T6, permet d'obtenir une mesure proportionnelle à la valeur du courant collecteur du transistor T5.

Dans le même temps, le transistor T3 fonctionne également avec un point de fonctionnement à la limite du blocage et du début de conduction. Sa polarisation est fixée par le courant dans la résistance de collecteur R61 du transistor T6, ce courant étant sensiblement égal au courant d'émetteur de ce même transistor. Lorsque la photodiode 4 délivre un faible courant dans la base du transistor T1, ceci se traduit par un faible courant d'émetteur sur l'émetteur du transistor T3. Le transistor T30 est alors bloqué et la tension de sortie aux bornes de la résistance de collecteur R32 est alors sensiblement nulle, ce qui correspond à la délivrance d'un signal logique à l'état bas. Lorsque le signal délivré par la photodiode 4 est suffisant, le courant d'émetteur du transistor T3 augmente, le transistor T30 commute et passe alors à l'état saturé, la tension aux bornes de R32 est sensiblement égale à VS et on a alors la délivrance d'un signal logique à l'état haut en sortie du dispositif amplificateur.

Ce fonctionnement du dispositif amplificateur dépend donc très fortement du point de fonctionnement du transistor T5. Or celui-ci dépend de façon complexe de la résistance R10 de l'impédance équivalente base-émetteur du transistor T5, de la tension aux bornes du condensateur C8 ainsi que de la charge constituée par l'ensemble du transistor T1, de la résistance R11, du transistor T11 et du condensateur C10, et enfin du courant inverse de la photodiode 4. Tous ces paramètres varient en fonction du temps, de la température et des composants eux-mêmes. Il est donc important d'asservir électroniquement le point de fonctionnement du transistor T5 car un réglage fixe ne saurait compenser les multiples causes de variation du courant collecteur de ce transistor T5. Cet asservissement va être réalisé par la boucle d'asservissement ci-dessus décrite. En effet, lorsque la tension aux bornes de la résistance R60 augmente, le transistor T7 se sature. La tension de grille du transistor à effet de champ T8 devient négative et le courant de charge du condensateur C8 décroît donc la tension à ses bornes. En conséquence, le courant collecteur du transistor T5 décroît et donc, dans le même temps, la tension aux bornes de la résistance R60. Si cette tension aux bornes de la résistance R60 diminue, la tension de grille du transistor à effet de champ T8 diminue et donc le courant dans le transistor T8 augmente donc la tension aux bornes du condensateur et en conséquence le courant collecteur du transistor T5 ainsi que la tension aux bornes de la résistance R60. On a donc bien un asservissement du point de fonctionnement du premier étage 5.

On a réalisé par ce montage un dispositif à seuil de conduction dépendant du gain en courant du transistor T1 et du compromis impédance équivalente base-émetteur du transistor T5-résistance de collecteur R10 du transistor T2. On a d'autre part réalisé un couplage total en courant entre le transistor T1 et le transistor T5 malgré l'utilisation d'une grande impédance de sortie du transistor T1 ainsi qu'une faible puissance du signal. On obtient un courant de repos, c'est-à-dire un courant lorsqu'aucun signal n'est reçu par la photodiode, extrêmement faible pour l'ensemble T1-T5 (de l'ordre de 12 microampères maximum). On obtient également une vitesse de commutation élevée malgré les impédances élevées et les faibles courants utilisés ainsi qu'une ampli fication en courant décroissant lorsque le signal d'entrée augmente.

En effet, lorsque la variation du courant collecteur du transistor T1 augmente, l'impédance équivalente base-émetteur du transistor T5 diminue. La charge du transistor T1 constituée dans l'ensemble R10 en parallèle avec l'impédance équivalente base-émetteur du transistor T5, diminue. Par conséquent le gain en courant du transistor T1 étant proportionnel à sa charge, celui-ci décroît. Le gain est donc maximum à faibles signaux, et sa décroissance en fonction du signal évite les appels de courant élevé que pourrait créer un gain constant à forts signaux. Cet effet est renforcé par le réseau d'anti-saturation composé des résistances R90 et R91. Ce réseau est notamment nécessaire lors d'emplois de fibres courtes.

Le rôle de la résistance R90 est de décharger la capacité parasite émetteur-base du transistor T5 au blocage de celui-ci. Pour de faibles courants, la résistance R91 n'intervient pas, mais dès que l'impédance équivalente base-émetteur du transistor T5 prend une valeur proche de la valeur de la résistance R91 par l'augmentation du courant de base, la résistance R91 crée un pont diviseur avec l'impédance équivalente base-émetteur et limite ainsi la tension base-émetteurs du transistor T5 et fixe par conséquent le courant maximum de base de ce transistor et donc son courant collecteur.

Un tel dispositif amplificateur a permis la réalisation d'une liaison informatique à 19200 bauds, sur une distance de 200 mètres de fibre optique plastique avec une consommation au repos de 20 micro-Ampères sous 5 Volts. L'émetteur de lumière était constitué d'une simple diode électroluminescente.

La réalisation du dispositif amplificateur selon l'invention est possible sous forme de circuit intégré. On peut alors, dans cette éventualité, avantageusement concevoir, dans une variante de réalisation, que l'étage relais soit constitué d'un circuit électronique assurant une fonction de miroir afin de renvoyer les signaux émis par le transistor T5 vers l'étage de sortie et vers la boucle d'asservissement.

Un tel dispositif amplificateur peut également constituer les moyens récepteurs pour détecter la lumière transmise par une fibre notamment dans le cas d'un dispositif pour détecter à distance le déplacement relatif de deux éléments, dispositif tel que décrit dans la Demande de Brevet français au nom de la Demanderesse déposée sous le N° 87 07422. En adjoignant sur le circuit imprimé du dispositif selon l'invention une diode électroluminescente, on constitue ainsi à la fois les moyens émetteurs et les moyens récepteurs du dispositif de la Demande de Brevet 87 07422. Ce dispositif fonctionne alors en "logique négative", c'est-à-dire à l'état de travail lorsque la fibre n'est pas endommagée et à l'état de repos dans le cas contraire.

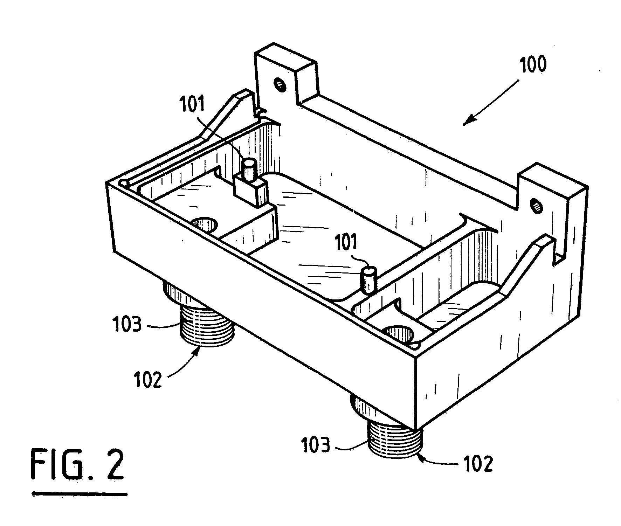

A cet effet, le circuit imprimé du dispositif selon l'invention peut être rangé dans un support opaque, constituant un blindage, tel que représenté sur la figure 2. Sur cette figure, on voit que l'on a représenté par 100 un tel support. Celui-ci est constitué d'une caisse, dont l'intérieur comporte des travées pour supporter le circuit imprimé ainsi que des plots de positionnement 101 pour positionner correctement le circuit imprimé sur les travées. Le fond de cette caisse comporte, à l'extérieur, deux connecteurs femelles 102, munis de filetages 103 destinés à recevoir les connecteurs mâles des deux extrémités de la fibre optique.

Il est bien entendu que le mode de réalisation ci-dessus décrit n'est aucunement limitatif et peut donner lieu à toute modification désirable, sans sortir pour cela du cadre de l'invention.

**Revendications**

1. Dispositif amplificateur à entrée analogique de faible puissance et à sortie logique, notamment adaptable sur un capteur (4), en particulier une photodiode, comprenant un étage d'entrée (1) formant préamplificateur à bas niveau et haute impédance, des moyens amplificateurs intermédiaires (2) et un étage de sortie (3) propre à transformer la sortie de ces moyens amplificateurs intermédiaires (2) en signal logique, caractérisé en ce que les moyens amplificateurs intermédiaires (2) comprennent un premier étage (5) dont le point de fonctionnement est réglé entre un état de blocage correspondant à la délivrance par l'étage de sortie d'un signal logique à l'état bas et un état de début de conduction correspondant à la délivrance par l'étage de sortie (3) d'un signal logique à l'état haut.

2. Dispositif selon la revendication 1, caractérisé en ce que l'étage d'entrée formant préamplificateur (1) comprend un transistor bipolaire (T1) opérant à très faible courant de collecteur, en ce que ledit premier étage (5) comprend un transistor bipolaire (T5) de polarité opposée, dont le point de fonctionnement est réglé entre ledit état de blocage et ledit état de début de conduction, dont la maille base-émetteur comprend la résistance de collecteur du transistor (T1) de l'étage d'entrée, laquelle a une valeur faible par rapport à l'impédance équivalente base-émetteur dudit transistor bipolaire (T5) du premier étage (5) lorsque, ledit premier étage est à l'état de blocage et en ce que ladite impédance équivalente a une valeur faible par rapport à ladite résistance de collecteur lorsque ledit premier étage (5) est à l'état de début de conduction.

3. Dispositif selon la revendication 2, caractérisé en ce que la maille base-émetteur du transistor bipolaire (T5) dudit premier étage (5) comprend en outre un étage anti-saturation (9) constitué d'une résistance supplémentaire (R90) placée entre la base et l'émetteur du transistor bipo laire (T5) du premier étage et d'une résistance de liaison (R91) placée entre le collecteur du transistor bipolaire (T1) de l'étage d'entrée (1) et la base du transistor bipolaire (T5) du premier étage (5).

4. Dispositif selon la revendication 2, caractérisé en ce que les moyens amplificateurs intermédiaires (2) comprennent en outre une boucle d'asservissement du point de fonctionnement dudit premier étage (5).

5. Dispositif selon la revendication 4, caractérisé en ce que la boucle d'asservissement est constituée, d'une part, d'un étage comparateur (7), comparant une information relative au point de fonctionnement dudit premier étage (5) avec une information de référence, d'autre part un étage intégrateur (8) pour régler ledit point de fonctionnement.

6. Dispositif selon la revendication 2, caractérisé par le fait que les moyens amplificateurs intermédiaires (2) comprennent en outre un étage relais (6) situé entre ledit premier étage (5) et, d'une part, ledit étage de sortie et, d'autre part, ladite boucle d'asservissement.

7. Dispositif selon la revendication 6, caractérisé en ce que l'étage relais (6) est constitué d'un transistor bipolaire (T6) de polarité opposée à celle du transistor bipolaire (T5) du premier étage, en ce que la base du transistor bipolaire (T6) dudit étage relais est reliée au collecteur du transistor bipolaire (T5) dudit premier étage (5), en ce que le collecteur du transistor bipolaire (T6) dudit étage relais (6) est relié à l'entrée de l'étage de sortie (3) et en ce que l'émetteur de transistor bipolaire (T6) dudit étage relais est relié à l'entrée de la boucle d'asservissement.

8. Dispositif selon la revendication 6, caractérisé en ce que l'étage relais (6) assure une fonction de miroir afin de renvoyer les signaux émis par ledit premier étage (5) vers l'étage de sortie (3) de la boucle d'asservissement.

9. Dispositif selon les revendications 5 et 6 prises en combinaison, caractérisé en ce que l'étage comparateur (7) de la boucle d'asservissement est constitué d'un transistor bipolaire (T7) de polarité identique à celui dudit étage d'entrée (1) dont la base est reliée à la sortie de l'étage relais (6) et dont le collecteur est relié à l'entrée du circuit intégrateur (8), ladite information de référence étant définie par sa tension de seuil base-émetteur.

10. Dispositif selon la revendication 9, caractérisé en ce que l'étage intégrateur (8) comprend un transistor à effet de champ (T8) d'une polarité identique au transistor bipolaire (T5) du premier étage (5), dont la grille est reliée au collecteur du transistor bipolaire (T7) de l'étage comparateur (7).

11. Dispositif selon l'une des revendications précédentes, caractérisé en ce qu'il comprend en outre une photodiode (4) montée à l'entrée de l'étage d'entrée (1).

12. Dispositif selon l'une des revendications 1 à 11, caractérisé en ce que ledit étage d'entrée (1), ledit étage de sortie (3), et lesdits moyens intermédiaires (2) sont logés dans un support opaque (100) comprenant au moins un connecteur femelle (102) muni de moyens d'attache (103) et susceptible de recevoir au moins un connecteur mâle d'une fibre optique, notamment plastique.

FIG. 1

0301963

FIG. 2

100

101

101

103

102

103

102

0301963